# EUROPÄISCHE PATENTSCHRIFT

(11) **EP 0 791 444 B1**
(45) Veröffentlichungstag und Bekanntmachung des Hinweises auf die Patenterteilung: **12.08.1998**
(21) Anmeldenummer: 97103164.6
(22) Anmeldetag: 27.02.1997
(51) Int. Cl.: B28D 5/02, B28D 1/00, B24B 7/22, B24B 47/22, B24B 49/03, B23Q 15/04

(54) **Verfahren zur Herstellung von Halbleiterscheiben**
Wafer manufacturing process
Procédé de fabrication de plaquettes semi-conductrices

(30) Priorität: 29.02.1996 DE 19607695
(43) Veröffentlichungstag der Anmeldung: 27.08.1997
(73) Patentinhaber: Wacker Siltronic Gesellschaft für Halbleitermaterialien Aktiengesellschaft, 84489 Burghausen (DE)
(72) Erfinder: Malcok, Hanifi, 84489 Burghausen (DE)
(74) Vertreter: Rimböck, Karl-Heinz, Dr.

(56) Entgegenhaltungen:
- EP-A- 0 417 644
- US-A- 4 967 461
- US-A- 5 329 733
- PATENT ABSTRACTS OF JAPAN vol. 007, no. 012 (M-186), 19.Januar 1983 & JP 57 168854 A (TOUKIYOU SEIMITSU:KK), 18.Oktober 1982,

## Beschreibung

Gegenstand der Erfindung ist ein Verfahren zur Herstellung von Halbleiterscheiben durch wiederholte Abfolge von Schleifen der Stirnfläche eines Einkristalls mit einem Schleifwerkzeug und Abtrennen einer Halbleiterscheibe vom Einkristall mit einem Trennwerkzeug, wobei beim Schleifen ein Schleifabtrag von einer bestimmten Dicke erzeugt wird, und die Halbleiterscheibe in einer Schneidebene abgetrennt wird, die möglichst parallel zur geschliffenen Stirnfläche liegt.

Mit dem Schleifen der Stirnfläche des Einkristalls wird eine erste ebene Seitenfläche der Halbleiterscheibe erzeugt. Nach dem Abtrennen der Halbleiterscheibe vom Einkristall wird sie als Referenzfläche verwendet und die gegenüberliegende Seitenfläche parallel zu dieser Referenzfläche geschliffen. Das gewünschte Resultat ist eine Halbleiterscheibe mit ebenen und parallelen Seitenflächen. In der US-A-4,967,461 ist anschaulich beschrieben, wie mit dem Schleifen der Stirnfläche des Einkristalls Unebenheiten beseitigt werden, die auf Auslenkungen des Sägeblatts während des Abtrennens einer Halbleiterscheibe zurückzuführen sind und zu durchgebogenen (warped) Halbleiterscheiben führen würden. Üblicherweise wird das Sägeblatt einer Innenlochsäge als Trennwerkzeug eingesetzt. Während sich das Sägeblatt durch den Einkristall arbeitet, treten Sägekräfte in Erscheinung, die das Sägeblatt aus der vorgesehenen, parallel zur geschliffenen Stirnfläche des Einkristalls liegenden Schneidebene auslenken. Die tatsächliche Schneidebene ist daher nicht vollkommen eben, sondern leicht gebogen und diese Unebenheit spiegelt sich in der Beschaffenheit der Stirnfläche des Einkristalls wider. Bevor die nächste Halbleiterscheibe abgetrennt werden kann, muß die Stirnfläche wieder geschliffen werden.

Die wiederholte Abfolge von Schleifen der Stirnfläche des Einkristalls und Abtrennen einer Halbleiterscheibe vom Einkristall beansprucht sowohl das Schleifwerkzeug, als auch das Trennwerkzeug. Der Zustand des Schleifwerkzeugs kann mit einem Phertometer bestimmt werden. Dazu bedarf es jedoch einer längeren Stillstandszeit der Schleifmaschine, da die Untersuchung am Schleifwerkzeug vorgenommen wird und für den Aus- und Einbau sowie die Neujustierung des Schleifwerkzeugs viel Zeit aufgewendet werden muß. Abnutzungserscheinungen oder Änderungen von Betriebsparametern können dazu führen, daß sich das Auslenkungsverhalten des Sägeblatts im Lauf der Zeit verändert und der Schnittverlauf beim Abtrennen einer Halbleiterscheibe verschieden ist vom Schnittverlauf beim Abtrennen der folgenden Halbleiterscheibe. Es wurden deshalb Sensoren entwickelt, um Veränderungen des Schnittverlaufs bereits während des Trennvorgangs verfolgen zu können. Geeignete Sensoren sind beispielsweise in der US-A-4,991,475 erwähnt.

Beim Schleifen der Stirnfläche des Einkristalls wird versucht, den Schleifabtrag auf ein Minimum zu begrenzen. Der Schleifabtrag wird in einer Längeneinheit angegeben. Er entspricht dem Abstand zwischen der geschliffenen Stirnfläche und der höchsten Materialerhebung auf der ungeschliffenen Stirnfläche. Ist der gewählte Schleifabtrag zu hoch, wird Material verschwendet und die Ausbeute an Halbleiterscheiben je Einkristall reduziert. Ist der Schleifabtrag zu niedrig, werden die Unebenheiten auf der Stirnfläche des Einkristalls nicht ausreichend beseitigt und die hergestellten Halbleiterscheiben sind mangelbehaftet.

Ein bestimmter Schleifabtrag kann sehr genau mit Hilfe der Zustelleinheit vorgegeben werden, die Schleifwerkzeug und/oder Einkristall zum Zwecke des Schleifens bewegt. Ein vorab festgelegter Soll-Schleifabtrag kann sich jedoch bald als zu niedrig erweisen, beispielsweise, weil sich der Betrag der Auslenkung des Sägeblatts im Verlauf der Scheibenherstellung erhöht hat. Andererseits kann beispielsweise in Folge einer Abnutzung des Sägeblatts der von diesem im Einkristall verursachte Sägespalt dünner werden, so daß bei einer Beibehaltung des ursprünglichen Schleifabtrags mehr Material als notwendig von der Stirnfläche des Einkristalls geschliffen würde.

Da der vorgegebene Schleifabtrag und der tatsächlich notwendige Schleifabtrag verschieden sein können, besteht das dringende Bedürfnis, den Schleifabtrag zumindest von Zeit zu Zeit bestimmen zu können. Dies ist jedoch nicht einfach. Eine Methode besteht darin, daß in regelmäßigen Abständen eine Halbleiterscheibe vom Einkristall abgetrennt wird, ohne daß zuvor die Stirnfläche des Einkristalls geschliffen worden ist. Der Schleifabtrag ergibt sich dann unmittelbar aus der Dicke der Halbleiterscheibe, vorausgesetzt, die Trennbedingungen hatten sich seit dem vorletzten Abtrennen einer Halbleiterscheibe nicht verändert. Gleichbleibende Trennbedingungen können angenommen werden, wenn Sensoren am Sägeblatt keine wesentliche Veränderung des Schnittverlaufs während des Abtrennens zweier, aufeinander folgender Halbleiterscheiben erkennen lassen. Nachteilig an der beschriebenen Methode ist insbesondere, daß die untersuchte Halbleiterscheibe als Ausschuß die Ausbeute vermindert, weil ihr die ebene Referenzfläche fehlt und sie nicht wie vorgesehen verwendet werden kann.

Die Aufgabe der vorliegenden Erfindung bestand deshalb darin, das Herstellungsverfahren für Halbleiterscheiben zu verbessern und insbesondere eine vorteilhaftere Methode zur Bestimmung des Schleifabtrags anzugeben.

Gegenstand der Erfindung ist ein Verfahren der eingangs genannten Gattung, das dadurch gekennzeichnet ist, daß
a) ein Teil der Oberfläche eines Hilfskörpers mitgeschliffen wird, wobei die Oberfläche des Hilfskörpers und die Stirnfläche im wesentlichen in einer Ebene liegen, und die Dicke des vom Hilfskörper durch Schleifen abgetragenen Materials im wesentlichen dem Schleifabtrag entspricht;
b) der Hilfskörper in der Schneidebene mit dem Trennwerkzeug eingeschnitten wird und ein Einschnitt entsteht, der einen geschliffenen Teil und einen nichtgeschliffenen Teil aufweist, und
c) der Schleifabtrag bestimmt wird, und zwar entweder als Abstand zwischen der geschliffenen Oberfläche des Hilfskörpers und der Oberfläche des Hilfskörpers vor dem Schleifen, oder als Differenz der Dicke des Einschnitts im nicht-geschliffenen Teil und der Dicke der Halbleiterscheibe.

Die Bestimmung des Schleifabtrags kann in Abständen erfolgen, beispielsweise jedesmal, nachdem eine bestimmte Anzahl von Halbleiterscheiben erhalten worden ist. Es ist jedoch ebenso möglich, den Schleifabtrag für jede hergestellte Halbleiterscheibe zu bestimmen. Die Bestimmung des Schleifabtrags erfolgt vorzugsweise, wenn die Überwachung des Sägeblatts ergeben hat, daß sich die Trennbedingungen beim Abtrennen zweier, aufeinander folgender Halbleiterscheiben nicht wesentlich geändert haben. Der Fortgang der Scheibenherstellung wird weder verzögert, noch wird die Ausbeute an Halbleiterscheiben beeinträchtigt.

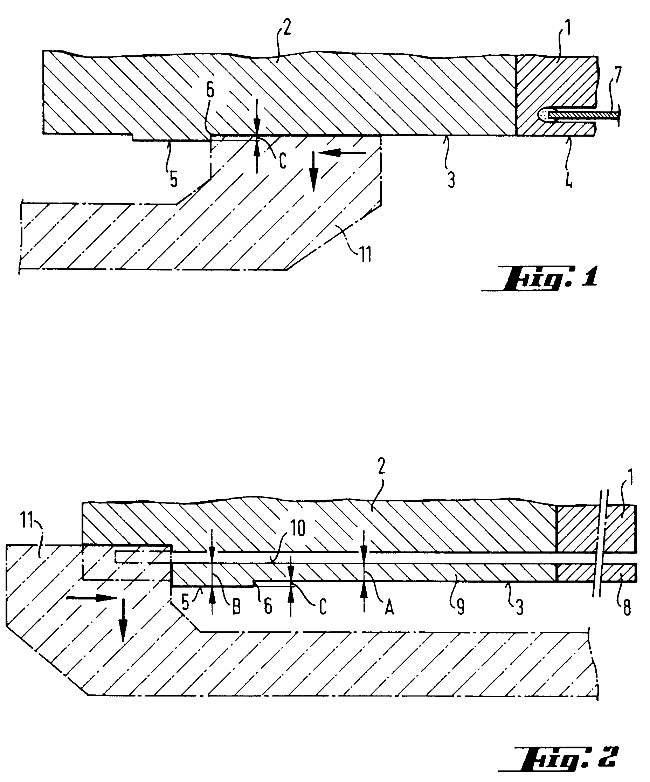

Die Erfindung wird nachfolgend mit Hilfe einer Figur beschrieben. Die Figur zeigt schematisch die Verhältnisse beim Schleifen der Stirnfläche eines Einkristalls (oberer Teil der Figur) und beim Abtrennen einer Halbleiterscheibe vom Einkristall (unterer Teil der Figur).

Das Schleifen kann vor oder gleichzeitig mit dem Abtrennen einer Halbleiterscheibe erfolgen. Es umfaßt nicht nur das Schleifen der Stirnfläche des Einkristalls 1, sondern auch das Schleifen der Oberfläche eines Hilfskörpers 2. Diese Oberfläche liegt im wesentlichen in derselben Ebene wie die nicht-geschliffene Stirnfläche. Bei der Wahl der Art des Hilfskörpers ist man weitgehend frei. Es bietet sich jedoch an, eine beispielsweise aus Kohlenstoff bestehende Leiste dafür zu verwenden, die üblicherweise ohnehin als Hilfsmittel beim Abtrennen von Halbleiterscheiben eingesetzt wird. Diese Leiste ist mit dem Einkristall verbunden, beispielsweise verklebt, und verhindert, daß eine Halbleiterscheibe bei der Trennung vom Einkristall beschädigt wird.

Außer der Stirnfläche des Einkristalls wird auch ein Teil der Oberfläche des Hilfskörpers mit dem Schleifwerkzeug 11 geschliffen, wobei der Schleifabtrag beim Einkristall im wesentlichen dem Schleifabtrag beim Hilfskörper entspricht. Folglich liegen die geschliffene Oberfläche 3 des Hilfskörpers und die geschliffene Stirnfläche 4 des Einkristalls in derselben Ebene. Der Abstand C zwischen der nicht-geschliffenen Oberfläche 5 und der geschliffenen Oberfläche 3 des Hilfskörpers entspricht dem tatsächlich erzielten Schleifabtrag. Im Prinzip kann dieser Abstand durch Begutachten der Tiefe der beim Schleifen entstandenen Stufe 6 gemessen werden. Es ist jedoch bevorzugt, für diese Bestimmung die vom Trennwerkzeug 7 abgetrennte Halbleiterscheibe 8 heranzuziehen. Die Schneidebene, auf der sich das Trennwerkzeug durch den Einkristall arbeitet, sollte möglichst parallel zur geschliffenen Stirnfläche liegen. In dieser Schneidebene wird auch der Hilfskörper 2 mit dem Trennwerkzeug eingeschnitten, so daß ein Einschnitt 9 entsteht, auf dessen Vorderseite sich die Stufe 6 befindet. Der tatsächlich erzielte Schleifabtrag C ergibt sich aus der Differenz der Dicke B des Einschnitts und der Dicke A der Halbleiterscheibe. Die Dicke B entspricht dem Abstand zwischen nicht-geschliffener Oberfläche 5 des Hilfskörpers und der vom Trennwerkzeug herausgeschnittenen Rückseite 10 des Einschnitts.

In der Praxis wird nach dem Einsatz des Trennwerkzeugs die Verbindung des Einschnitts zum Rest des Hilfskörpers mit dem Schleifwerkzeug abgestochen und die Halbleiterscheibe und der Einschnitt von einem Aufnehmer aufgenommen. Gegebenenfalls nach der Trennung der beiden Objekte erfolgt die Dickenmessung, wobei auch eine Mehrfachmessung möglich ist, mit der jeweils ein mittlerer Wert für die Dicke der Halbleiterscheibe und des Einschnitts ermittelt wird. Bevorzugt ist eine automatisierte Dickenmessung.

Der Einschnitt 9 ist auch noch anderweitig nützlich. Seine geschliffene Oberfläche 3 kann mit einem Phertometer untersucht werden. Auf Grund der Untersuchung ist ein Rückschluß auf das Profil des Schleifwerkzeugs möglich und ein Verschleiß des Schleifwerkzeugs frühzeitig erkennbar.

Gemäß einer Weiterbildung des Verfahrens ist vorgesehen, die Auslenkungen des Sägeblatts aus der vorgesehenen, parallel zur geschliffenen Stirnfläche des Einkristalls liegenden Schneidebene zu verfolgen und darauf basierend einen Soll-Schleifabtrag rechnerisch zu ermitteln. Der Soll-Schleifabtrag entspricht möglichst dem Schleifabtrag, der gerade ausreicht, um durch das Schleifen eine ebene Stirnfläche zu erzielen. Weicht der ermittelte Soll-Schleifabtrag von dem Schleifabtrag ab, der der Zustelleinheit ursprünglich vorgegeben war, wird die Zustelleinheit auf den Soll-Schleifabtrag automatisch oder manuell umprogrammiert. Der dann tatsächlich erfolgende Schleifabtrag wird dann auf die oben beschriebene Weise bestimmt und mit dem Soll-Schleifabtrag verglichen.

## Patentansprüche

1. Verfahren zur Herstellung von Halbleiterscheiben durch wiederholte Abfolge von Schleifen der Stirnfläche eines Einkristalls mit einem Schleifwerkzeug und Abtrennen einer Halbleiterscheibe vom Einkristall mit einem Trennwerkzeug, wobei beim Schleifen ein Schleifabtrag von einer bestimmten Dicke erzeugt wird, und die Halbleiterscheibe in einer Schneidebene abgetrennt wird, die möglichst parallel zur geschliffenen Stirnfläche liegt, dadurch gekennzeichnet, daß
a) ein Teil der Oberfläche eines Hilfskörpers mitgeschliffen wird, wobei die Oberfläche des Hilfskörpers und die Stirnfläche im wesentlichen in einer Ebene liegen, und die Dicke des vom Hilfskörper durch Schleifen abgetragenen Materials im wesentlichen dem Schleifabtrag entspricht;
b) der Hilfskörper in der Schneidebene mit dem Trennwerkzeug eingeschnitten wird und ein Einschnitt entsteht, der einen geschliffenen Teil und einen nichtgeschliffenen Teil aufweist, und
c) der Schleifabtrag bestimmt wird, und zwar entweder als Abstand zwischen der geschliffenen Oberfläche des Hilfskörpers und der Oberfläche des Hilfskörpers vor dem Schleifen, oder als Differenz der Dicke des Einschnitts im nicht-geschliffenen Teil und der Dicke der Halbleiterscheibe.

2. Verfahren nach Anspruch 1, dadurch gekennzeichnet, daß während des Abtrennens einer Halbleiterscheibe die Auslenkung des Trennwerkzeugs in Bezug auf eine vorgesehene Schneidebene gemessen und ein Soll-Schleifabtrag in Abhängigkeit der gemessenen Auslenkung ermittelt wird, der Soll-Schleifabtrag dem Schleifwerkzeug beim Schleifen der Stirnfläche des Einkristalls vorgegeben wird, und nach dem Abtrennen der nächsten Halbleiterscheibe der tatsächlich erzielte Schleifabtrag bestimmt wird.

3. Verfahren nach Anspruch 1, dadurch gekennzeichnet, daß die geschliffene Oberfläche des Hilfskörpers mit einem Phertometer untersucht wird und der Zustand des Schleifwerkzeugs mit Hilfe des Ergebnisses der Untersuchung abgeschätzt wird.

## Claims

1. Method of producing semiconductor wafers by a repeated sequence of grinding the end face of a monocrystal using a grinding tool and cutting a semiconductor wafer from the monocrystal using a cutting tool, a grinding abrasion of a specified depth being produced during grinding, and the semiconductor wafer being cut in a cutting plane which is as parallel as possible to the ground end face, characterized in that
a) a part of the surface of an auxiliary body is simultaneously ground, the surface of the auxiliary body and the end face lying substantially in one plane and the thickness of the material abraded from the auxiliary body by grinding being substantially equal to the grinding abrasion;
b) the auxiliary body in the cutting plane is cut into using the cutting tool and a cut section produced having a ground part and an unground part, and
c) the grinding abrasion is determined, either as the distance between the ground surface of the auxiliary body and the surface of the auxiliary body before grinding or as the difference in the thickness of the cut section in the unground part and the thickness of the semiconductor wafer.

2. Method according to Claim 1, characterized in that, during the cutting of a semiconductor wafer, the deflection of the cutting tool with reference to an intended cutting plane is measured and a required grinding abrasion is determined as a function of the measured deflection, the required grinding abrasion is set for the grinding tool for grinding the end face of the monocrystal, and, after the next semiconductor wafer has been cut, the grinding abrasion actually achieved is determined.

3. Method according to Claim 1, characterized in that the ground surface of the auxiliary body is investigated with a phertometer and the state of the grinding tool is assessed with the aid of the results of the investigation.

## Revendications

1. Procédé de fabrication de pastilles semi-conductrices par une séquence répétée de rectification de la face terminale d'un monocristal à l'aide d'un outil de rectification et de tronçonnage d'une pastille semi-conductrice du monocristal à l'aide d'un outil de tronçonnage, un enlèvement par rectification d'une épaisseur spécifique étant réalisé lors de la rectification, et la pastille semi-conductrice étant tronçonnée dans un plan de coupe, qui est aussi parallèle que possible à la face terminale rectifiée, caractérisé
a) en ce qu'une partie de la surface d'un corps auxiliaire est rectifiée conjointement, la surface du corps auxiliaire et la face terminale se situant pour l'essentiel dans un même plan, et l'épaisseur du matériau enlevé par rectification du corps auxiliaire correspondant, pour l'essentiel, à l'enlèvement par rectification;
b) en ce que le corps auxiliaire est entaillé dans le plan de coupe à l'aide de l'outil de tronçonnage et qu'il se forme une section coupée, qui présente une partie rectifiée et une partie non rectifiée, et
c) en ce que l'enlèvement par rectification est déterminé, et certes, soit en tant que distance entre la surface rectifiée du corps auxiliaire et la surface du corps auxiliaire avant la rectification, soit en tant que différence de l'épaisseur de la section coupée dans la partie non rectifiée et de l'épaisseur de la pastille semi-conductrice.

2. Procédé selon la revendication 1, caractérisé en ce que, pendant le tronçonnage d'une pastille semi-conductrice, la déflexion de l'outil de tronçonnage par rapport à un plan de coupe prévu est mesurée, et qu'un enlèvement par rectification de valeur consigne est déterminé en fonction de la déflexion mesurée, que l'enlèvement par rectification de valeur consigne est prescrit à l'outil de rectification lors de la rectification de la face terminale du monocristal, et qu'après le tronçonnage de la pastille semi-conductrice suivante, l'enlèvement par rectification effectivement obtenu est déterminé.

3. Procédé selon la revendication 1, caractérisé en ce que la surface rectifiée du corps auxiliaire est examinée avec un appareil Perthometer et que l'état de l'outil de rectification est évalué sur la base du résultat de cet examen.
